# EUROPEAN PATENT SPECIFICATION

(11) **EP 3 636 822 B1**
(45) Date of publication and mention of the grant of the patent: **23.02.2022**
(21) Application number: 18889801.9
(22) Date of filing: 16.08.2018
(51) Int. Cl.: D06F 37/04, G06F 30/23, D06F 37/22

(54) **WASHING MACHINE SUPPORT, WASHING MACHINE USING SUPPORT, AND STRUCTURAL OPTIMIZATION METHOD**
WASCHMASCHINENSTÜTZE, WASCHMASCHINE MIT VERWENDUNG DER STÜTZE UND STRUKTUROPTIMIERUNGSVERFAHREN
SUPPORT POUR LAVE-LINGE, LAVE-LINGE UTILISANT LE SUPPORT ET PROCÉDÉ D'OPTIMISATION STRUCTURALE

(30) Priority: 11.12.2017 CN 201711308481
(43) Date of publication of application: 15.04.2020
(73) Proprietor: Gree Electric Appliances (Wuhan) Co., Ltd., Wuhan, Hubei 430056 (CN); Gree Electric Appliances, Inc. of Zhuhai, Zhuhai, Guangdong 519070 (CN)
(72) Inventor: YANG, Yang, Zhuhai, Guangdong 519070 (CN); ZHANG, Youlin, Zhuhai, Guangdong 519070 (CN); HUANG, Haoqin, Zhuhai, Guangdong 519070 (CN); CHEN, Xing, Zhuhai, Guangdong 519070 (CN); LI, Qi, Zhuhai, Guangdong 519070 (CN); JING, Zhenyang, Zhuhai, Guangdong 519070 (CN)
(74) Representative: Corradini, Corrado
(86) International application number: PCT/CN2018/100775
(87) International publication number: WO 2019/114306

(56) References cited:
- EP-A1- 2 436 823
- WO-A1-2011/004313
- CN-A- 104 112 050
- CN-A- 107 938 253
- CN-U- 205 329 375
- CN-U- 207 699 864
- CN-Y- 200 985 440
- DE-A1- 4 326 496
- KR-A- 20090 038 185

## Description

### TECHNICAL FIELD

The present disclosure relates to the field of washing machine, and in particular, to a washing machine support, a washing machine having the same, and a structure optimization method.

### BACKGROUND

The washing machine support is used to support the inner drum of the washing machine, and it is also used to transmit the movement of the rotation shaft to the inner drum.

Because the washing machine support needs to bear the pressure loads and the torsion loads of the inner drum, sufficient structural strength is required to meet a demand of a certain service life. The cross section of a traditional support is a " 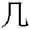 "-shaped structure or a " 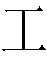 "-shaped structure. Although the washing machine support of such a structure can meet general requirements, if the washing machine operates at an ultra-high capacity for a long time, the problem of support fracture may occur. For another example, when the speed of 1400 rpm is satisfied, and the allowed design margin is not enough, the reliability of the product may be reduced during the long-term operation.

The patent application KR20090038185 describes a washing machine support according to the preamble of the independent claim 1.

### SUMMARY

In view of the defects in the prior art, an objective of the present disclosure is to provide a washing machine support, a washing machine having the same, and a structure optimization method, to improve the reliability of the washing machine support.

In the technical solution of the present disclosure, a washing machine support for supporting an inner drum of a washing machine, includes at least two supporting arms, each of the supporting arms includes a first supporting plate and a connecting plate; a first end of the connecting plate is connected to a first surface of the first supporting plate; a transition structure is provided at a junction of the first supporting plate and the connecting plate. The washing machine support further includes a second supporting plate arranged opposite to the first supporting plate, and a first surface of the second supporting plate is connected to a second end of the connecting plate. A transition structure is also provided at a junction of the second supporting plate and the connecting plate.

Preferably, the transition structure is a curved structure provided at the junction of the first supporting plate and the connecting plate.

Preferably, a first groove is provided on a second surface of the first supporting plate, and the first groove is disposed at a position corresponding to a position of the connecting plate. Preferably, a second groove is provided on a second surface of the second supporting plate, and the second groove is disposed at a position corresponding to a position of the connecting plate. Preferably, the washing machine support includes a support, and a depth of the first groove decreases outwards from a center of the support.

Preferably, the first groove is a V-shape groove.

Preferably, the first supporting plate and the second supporting plate are connected together at an end of the supporting arm by a connection part. According to the invention, a through groove is disposed in an end portion of the supporting arm and goes through the first supporting plate and the second supporting plate.

Preferably, a shape of the through groove is adapted to a shape of the end portion of the supporting arm, and is configured to make a material distribution at the end portion of the supporting arm tend to be uniform.

Preferably, the washing machine support includes a support, and the through groove is provided with a recess facing a center of the support.

Preferably, the recess is in a shape of a triangle.

Preferably, a width of the first supporting plate is less than a width of the second supporting plate.

Preferably, middle regions of the first supporting plate and the second supporting plate are waist-like structures.

Preferably, a waisting degree of the waist-like structure of the first supporting plate is greater than a waisting degree of the waist-like structure of the second supporting plate.

Preferably, a height of the connecting plate decreases outwards from a center.

Preferably, three or more supporting arms are provided; the first supporting plates of two adjacent supporting arms smoothly transition and are smoothly connected; the second supporting plates of two adjacent supporting arms smoothly transition and are smoothly connected; and a spacing plate is provided between a junction of the first supporting plates of two adjacent supporting arms and a junction of the second supporting plates of two adjacent supporting arms.

Preferably, a width of the first supporting plate is less than a width of the second supporting plate, and the spacing plate has a wedge-shaped structure corresponding to the width of the first supporting plate and the width the second supporting plate.

Preferably, the washing machine support includes a support, and a depth of the second groove decreases outwards from a center of the support.

Preferably, the washing machine support includes a support; a first groove is provided on a second surface of the first supporting plate; the first groove is disposed at a position corresponding to a position of the connecting plate; the washing machine support further includes a second supporting plate arranged opposite to the first supporting plate, and a first surface of the second supporting plate is connected to a second end of the connecting plate; depths of the first groove and the second groove decrease outwards from a center of the support. Preferably, the second groove is a V-shape groove.

Preferably, a first groove is provided on a second surface of the first supporting plate, and the first groove and the second groove are V-shape grooves.

The present disclosure further provides a washing machine, including the washing machine support above and the inner drum, and the washing machine support includes a support, and the support is connected to a rear connector of the inner drum.

The present disclosure further provides a structure optimization method for a washing machine support, including steps of:
S1. obtaining an original model of an original support, and performing a finite element analysis for the original model under maximum load working conditions;
S2. constructing an original feature model based on an analytic result;
S3. performing topological optimization;
S4. constructing a three-dimensional structure of a new model based on an optimized result;
S5. performing finite element analysis and testing for the three-dimensional structure of the new model.

Compared with the prior art, the present disclosure has at least the following beneficial effects: the transition structure is provided at the junction of the first supporting plate and the connecting plate; the transition structure reduces the concentration of stresses at the junction of the first supporting plate and the connecting plate, increases the strength of the supporting arm and reduces the probability of fracture.

### BRIEF DESCRIPTION OF DRAWINGS

The accompanying drawings attached to the specification form a part of the disclosure and are intended to provide a further understanding of the present disclosure. The illustrative embodiments of the disclosure and the description thereof are used for explanations of the present disclosure, and do not constitute improper limitations of the present disclosure. In the accompanying drawings:
FIG. 1 is an exploded view illustrating a matched structure of a washing machine support and an inner drum of a washing machine of the present disclosure.
FIG. 2 is a bottom view of the matched structure of the washing machine support and the inner drum of the washing machine according to the present disclosure.
FIG. 3 is a cross-sectional view of supporting arms of the washing machine support of the present disclosure.
FIG. 4 is a cross-sectional view of an upper portion of the washing machine support of the present disclosure.
FIG. 5 is a schematic view of the washing machine support of the present disclosure from a first view angle.
FIG. 6 is a schematic view of the washing machine support of the present disclosure from a second view angle.
FIG. 7 is a schematic view illustrating a fluid flow direction of the washing machine support of the present disclosure.
FIG. 8 is a flow chart of a structure optimization design for the washing machine support of the present disclosure.

### DETAILED DESCRIPTION OF DISCLOSED EMBODIMENTS

It should be noted that the embodiments in the present disclosure and the features in the embodiments can be combined with each other if no conflicts occur. The disclosure will be described in detail below with reference to the accompanying drawings in combination with the embodiments.

It should be noted that terms used herein are only for the purpose of describing specific embodiments and not intended to limit the exemplary embodiments of the disclosure. The singular of a term used herein is intended to include the plural of the term unless the context otherwise specifies. In addition, it should also be appreciated that when terms "include" and/or "comprise" are used in the description, they indicate the presence of features, steps, operations, devices, components and/or their combination.

It should be noted that the terms "first", "second", and the like in the description, claims and drawings of the present disclosure are used to distinguish similar objects, and are not necessarily used to describe a specific order or order. It should be appreciated that such terms can be interchangeable if appropriate, so that the embodiments of the disclosure described herein can be implemented, for example, in an order other than those illustrated or described herein. In addition, the terms "comprise" , "have" and any deformations thereof, are intended to cover a non-exclusive inclusion, for example, a process, a method, a system, a product, or a device that includes a series of steps or units is not necessarily limited to explicitly list those steps or units, but can include other steps or units that are not explicitly listed or inherent to such a process, a method, a product or a device.

For convenience of description, spatially relative terms such as "above", "over", "on a surface of", "upper", etc., may be used herein to describe the spatial position relationships between one device or feature and other devices or features as shown in the drawings. It should be appreciated that the spatially relative term is intended to include different directions during using or operating the device other than the directions described in the drawings. For example, if the device in the drawings is inverted, the device is described as the device "above other devices or structures" or "on other devices or structures" will be positioned "below other devices or structures" or "under other devices or structures". Thus, the exemplary term "above" can include both "above" and "under". The device can also be positioned in other different ways (rotating 90 degrees or at other orientations), and the corresponding description of the space used herein is interpreted accordingly.

Now, the exemplary embodiments of the disclosure will be further described in detail with reference to the accompanying drawings. However, these exemplary embodiments can be implemented in many different forms and should not be construed as only limitation of the embodiments described herein. It should be appreciated that the embodiments are provided to make the present disclosure disclosed thoroughly and completely, and to fully convey the concepts of the exemplary embodiments to those skilled in the art. In the accompanying drawings, for the sake of clarity, the thicknesses of layers and regions may be enlarged, and a same reference sign is used to indicate a same device, thus the description thereof will be omitted.

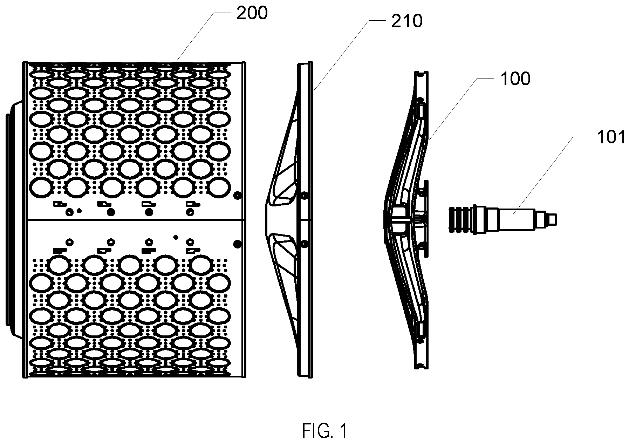

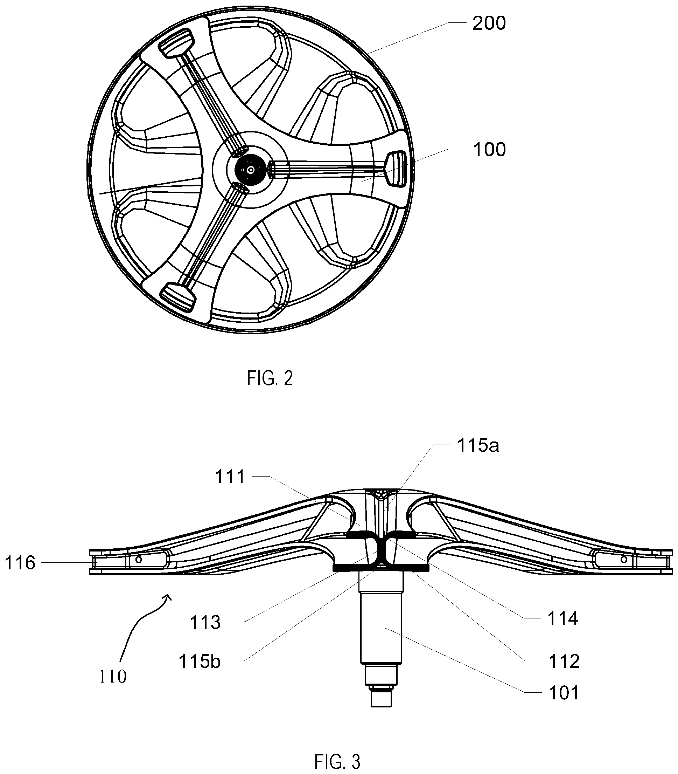

As shown in FIG. 1 and FIG.2, the present disclosure provides a washing machine support. The washing machine support includes a support 100 for supporting the inner drum 200 of the washing machine. The support 100 is provided on a rear connector 210 of the inner drum 200 of the washing machine through supporting arms 110 of the support. Specifically, through fixing a screw in a screw hole (not shown in figures) on each supporting arm 110, the support is connected to the rear connector 210. As shown in FIGS. 3 to 7, the support 100 includes at least two supporting arms 110. For example, two, four, or five supporting arms are provided, as long as they can match the rear connector of the inner drum of the washing machine. This embodiment is described by taking a support 100 including three supporting arms 110 as an example. Each of the supporting arms 110 includes a first supporting plate 111 and a connecting plate 113; a first end of the connecting plate 113 is connected to a first surface of the first supporting plate 111; a transition structure 114 is provided at a junction of the first supporting plate 111 and the connecting plate 113. The transition structure reduces the concentration of stresses at the junction of the first supporting plate 111 and the connecting plate 113, increases the strength of the supporting arm 110, and reduces the probability of fracture.

The support 100 further includes a second supporting plate 112 arranged opposite to the first supporting plate 111. A first surface of the second supporting plate 112 is connected to a second end of the connecting plate 113. The arrangement of the second supporting plate 112 provides a better bottom support and avoids an excessive concentration of forces exerted on the connecting plate 113, which makes the structural strength of the support 100 stronger. In addition, according to the invention, a transition structure 114 is also provided at a junction of the second supporting plate 112 and the connecting plate 113.

As an option of this embodiment, the transition structure 114 is a curved structure provided at the junction of the first supporting plate 111 and the connecting plate 113, and the curved structure performs a function of dispersing stresses well, thereby improving the strength of the junction. Of course, as another alternative structure, the transition structure 114 can also be a non-curved planar structure, for example, it may be a transition plane with a transition angle of 45 degrees or other degrees. The transition structure between the second supporting plate 112 and the connecting plate 113 also has the same structure, so as to improve the overall structural strength. As a further improvement of this embodiment, a first groove 115a is provided on the second surface of the first supporting plate 111. The first groove 115a is disposed at a position corresponding to a position of the connecting plate 113. Specifically, the connecting plate 113 extends outwards from the center of the support 100, and the position of the first groove 115a correspondingly extends outward from a starting position of the connecting plate 113 to an end of the connecting plate 113. Of course, the first groove 115a does not necessarily have to be starting from the starting position of the extension of the connecting plate 113, and the first groove 115a does not necessarily have to be ending at the ending position of the extension of the connecting plate 113.

Similarly, a second groove 115b is also provided on the second surface of the second supporting plate 112. The second groove 115b is also disposed at a position corresponding to the position of the connecting plate 113, and the arrangement mode of the second groove is the same as that of the groove on the first supporting plate 111, or the second groove can be arranged to have a length different from that of the first groove. For example, if the length of the first groove 115a is shorter, the length of the second groove 115b can be provided to be longer, so that the bottom can bear greater forces.

Taking an arrangement mode that the length of the first groove 115a and the length of the second groove 115b are identical to the length of the connecting plate 113 as an example, such a structure makes the structure of the supporting arm 110 be in an "χ"-like shape overall, so that the material of each part of the supporting arm distribute uniformly, thereby effectively preventing the stresses from being concentrated at a certain position, improving the structural strength of the supporting arm 110, and further reducing the probability of fracture.

As a further improvement of this embodiment, the depth of the first groove 115a or the depth of the second groove 115b decreases outward from the center of the support, or the depths of the first groove 115a and the depth of the second groove 115b both decrease outward from the center of the support. In this embodiment, since the height of the connecting plate 113 decreases outward from the center of the support 100, the depth of the first groove 115a or the depth of the second groove 115b decreases outward from the center of the support 100, thereby making the material of each part of the supporting arm distribute uniformly, making the thickness tend to be consistent, and helping to improve the flex -resistance of the supporting arm 110. Moreover, in this embodiment, if a casting part of casting aluminum is employed in manufacturing, a high uniformity of material thickness is beneficial to interior heat dissipation and solidification, thereby reducing incidence of pores during casting.

Alternatively, the first groove 115a or the second groove 115b can be a V-shape groove, or both the first groove 115a and the second groove 115b are V-shape grooves. Of course, the V-shape grooves described in this embodiment are not absolutely V-shaped, but as shown in FIG.3, the bottom of the V-shaped groove is a smoothly curved transition surface, the curved surfaces with opposite convex parts at two sides of the groove smoothly transition to the second surface of the second supporting plate 111 and the second surface of the second supporting plate 112 respectively, so that the material distribution of the entire section is more uniform and the flex-resistance is better. Of course, the first groove 115a and the second groove 115b can also be U-shaped or W-shaped, which can be configured according to the arrangement of the transition structure 114, so as to achieve the effects of uniform material distribution.

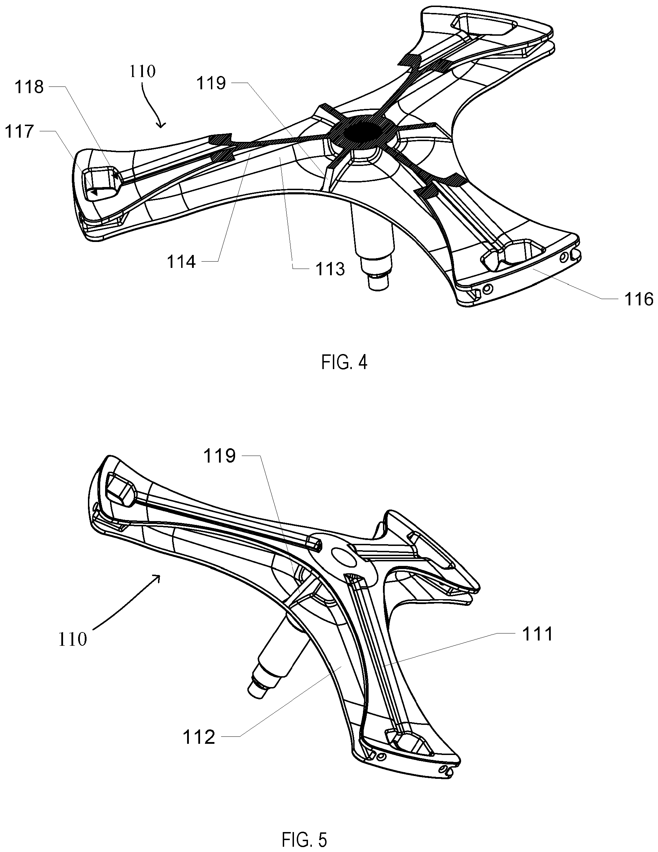

As shown in FIG. 3 and FIG. 4, the first supporting plate 111 and the second supporting plate 112 are connected together at the end of the supporting arm 110 by a connection part 116. The connection part 116 provides the first supporting plate 111 and the second supporting plate 112 with an edge supporting, thereby ensuring the structural strength of the end of the supporting arm 110.

According to the invention, as shown in FIG. 4, a through groove 117 is disposed in the end portion of the supporting arm 110 and goes through the first supporting plate 111 and the second supporting plate 112. The end portion of a supporting plate of a traditional support is mostly W-shaped or " 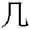 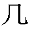 "-shaped, therefore sediments are apt to be accumulated, yet such a closed arrangement disables proper flushing by fluids. Compared with the traditional support, the through groove 117 in this embodiment allows the fluid to flow through the through groove while the support 100 is rotating, and the sediments inside the groove and at the opening of the groove can be flushed by fluids, thereby improving the cleanness of the surface of the support 100.

In this embodiment, the shape of the through groove 117 is adapted to the shape of the end portion of the supporting arm 110, so that the material distribution at the end portion of the supporting arm 110 tends to be uniform. As shown in the figure, the through groove 117 has a shape formed by connecting two "C" shapes opposite to each other, so that the material on both sides of the end portion and on one side of the end portion is uniformly distributed, to ensure the structural strength of the end portion. Moreover, the circumferential wall structure of the through groove 117 plays a favorable role in dispersing stresses.

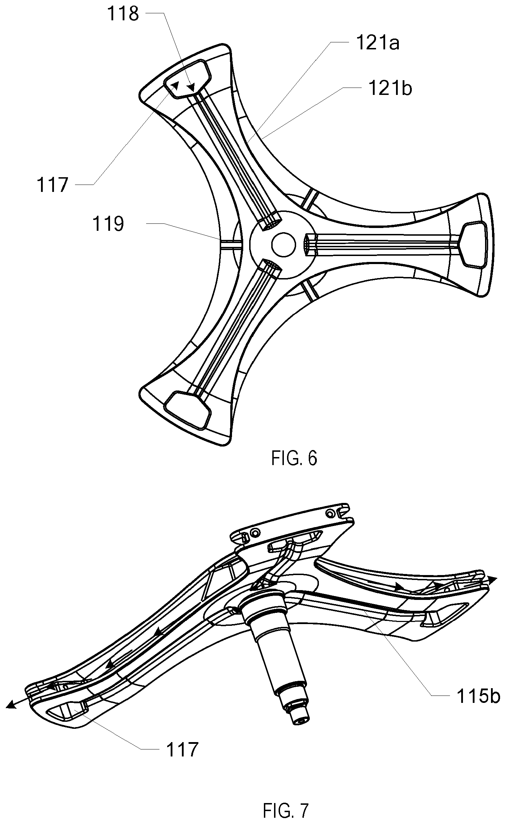

In this embodiment, as shown in FIG. 4 and FIG. 6, the through groove 117 is provided with a recess 118 facing the center of the support. As a structure of the recess 118, the recess 118 can be in a shape of a triangle which further improves the uniformity of the material of the end portion.

In addition, as shown in FIG.7, a fluid rotating groove is formed by the structural arrangements of the first supporting plate 111, the second supporting plate 112, and the connecting plate 113. The recess of the through groove 117 (or a triangular structure) facing the center of the support 100 favorably acts to guide the fluid in the process of flowing out of the fluid rotating groove, thus the flow field is more streamlined, thereby reducing the wind-resistance of the flow field and increasing the coefficient of performance (COP).

In this embodiment, the width of the first supporting plate 111 is less than the width of the second supporting plate 112, and as a whole, the cross section is similar to a trapezoidal section, so that the structure of the support 100 is more lightweight, and that the support fits the features of the rear end surface of the inner drum.

As a further improvement of this embodiment, as shown in FIG. 6, the middle regions of the first supporting plate 111 and the second supporting plate 112 are waist-like structures 121a and 121b, so that the supporting arm 110 extends outwards smoothly, and the flex-resistance of the supporting arm is improved. The waisting degree of the waist-like structure 121a of the first supporting plate 111 is greater than the waisting degree of the waist-like structure 121b of the second supporting plate 112. The waisting degree of the first supporting plate 111 being greater than that of the second supporting plate 112 enables the supporting arm to be connected to the lower end portion of the inner drum. Moreover, the smaller waisting degree of the second supporting plate 112 ensures that the second supporting plate 112 has better support strength.

In this embodiment, the height of the connecting plate 113 decreases outwards from the center, so that the support 100 can be better connected to the inner drum 200, and moreover, have a better support effect.

In this embodiment, three or more supporting arms 110 are provided. Where the first supporting plates 111 of two adjacent supporting arms 110 smoothly transition and are smoothly connected, and the second supporting plates 112 of two adjacent supporting arms 110 smoothly transition and are smoothly connected. A spacing plate 119 is provided between a junction of the first supporting plates 111 of two adjacent supporting arms 110 and a junction of the second supporting plates 112 of two adjacent supporting arms 110. In this embodiment, the simulation analysis result shows that the stress at the junction of the first supporting plates 111 of two adjacent supporting arms 110 and the stress at the junction of the second supporting plates 112 of two adjacent supporting arms 110 are great. When the spacing plate 119 is arranged between the first supporting plates 111 and the second supporting plates 112, the stresses can be transmitted effectively, especially when the support 100 is bearing a torsion load, the torsion-resistance is improved effectively.

As shown in FIG.5 and FIG.6, the width of the first supporting plate 111 is less than the width of the second supporting plate 112 (the width of the cross section extending outwards from the center of the support). The spacing plate 119 has a wedge-shaped structure corresponding to the width of the first supporting plate 111 and the width the second supporting plate 112. The wedge-shaped spacing plate can transmit the stresses effectively and evenly distribute the stresses onto the second supporting plate 112.

In this embodiment, the support 100 and a rigid rotation shaft 101 are integrally casted with aluminum, thereby ensuring the connection strength between the support 100 and the rotation shaft 101.

The washing machine support provided in this embodiment is verified by finite element analysis. Compared with the traditional support, the washing machine support in this embodiment has a great stress improvement under pressure loads, and also has a great stress improvement under torsion loads. The washing machine support provided in this embodiment has a simple structure, requires less material, and meets the requirements of light weight.

In this embodiment, a third supporting plate can be further provided between the first supporting plate 111 and the second supporting plate 112, to form a " 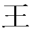 "-shaped supporting structure, yet a whole weight of such a structure of a support is heavier, which cannot meet the requirements of light weight.

Referring to FIG. 1 and FIG. 2, the present disclosure also provides a washing machine. The washing machine is provided with the support 100 of this embodiment. The support 100 is provided with a supporting arm 110, and the supporting arm 110 is provided with a screw hole. Therefore, the supporting arm 110 is connected to the rear connector 210 of the inner drum 200 with screw. Of course, the connection mode of connecting the supporting arm with the inner drum is not limited to the connection mode by screwing.

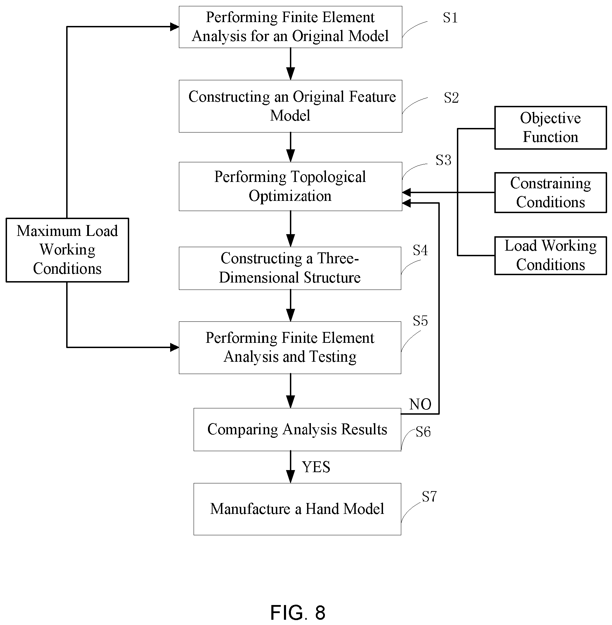

The present disclosure also provides a structure optimization method for a washing machine support. As shown in FIG. 8, the method includes following steps:
S1. obtain an original model of an original support, and perform a finite element analysis for the original model under maximum load working conditions;
S2. construct an original feature model based on an analytic result;
S3. perform topological optimization; during the optimization process, set conditions including an objective function, constraining conditions and load working conditions according to a general working situation of the support;
S4. construct a three-dimensional structure of a new model based on an optimized result;
S5. perform finite element analysis and testing for the three-dimensional structure of the new model;
S6. compare a finite element analysis result of the three-dimensional structure of the new model with the finite element analysis result of the original model, and perform a further optimization if requirements are not met.
S7. if the requirements are met, and if it is confirmed that the result is optimized, manufacture a hand model, and then perform relevant experiments and testing for the hand model.

Through the finite element analysis technology, the present disclosure realizes the simulations of the original model and the new model under the same pressure load and the same torsion load, thereby saving the model opening cost of the previous developing, and avoiding the problem that the product does not meet the test requirements after the model opening cost was invested.

In addition to the above description, it also should be noted that "one embodiment", "another embodiment", "an embodiment" and the like in the description refer to that a specific feature, a structure or a characteristic described in combination with the embodiment is included in at least one embodiment of the general description of the present disclosure. The same expression in various locations in the specification does not necessarily refer to the same embodiment. Furthermore, when a specific feature, a structure, or a characteristic are described in combination with any embodiments, what is claimed is that other embodiments which are combined to implement such a feature, a structure, or a characteristic are also included in the scope of the present disclosure.

In the above embodiments, the descriptions of the various embodiments have different emphases, and any portions that are not detailed in a certain embodiment can be seen in the related descriptions of other embodiments.

The above descriptions are merely the preferred embodiments of the present disclosure, and are not intended to limit the present disclosure. For those skilled in the art, various modifications and changes can be made for the present disclosure within the scope of the appended claims.

## Claims

1. A washing machine support (100) for supporting an inner drum (200) of a washing machine, comprising at least two supporting arms (110), wherein each of the supporting arms (110) comprises a first supporting plate (111), a connecting plate (113), and a second supporting plate (112) arranged opposite to the first supporting plate (111); a first end of the connecting plate (113) is connected to a first surface of the first supporting plate (111); a first surface of the second supporting plate (112) is connected to a second end of the connecting plate (113);
one transition structure (114) is provided at a junction of the first supporting plate (111) and the connecting plate (113); another transition structure (114) is provided at a junction of the second supporting plate (112) and the connecting plate (113); **characterized in that**,
a through groove (117) is disposed in an end portion of the supporting arm (110) and goes through the first supporting plate (111) and the second supporting plate (112).

2. The washing machine support (100) according to claim 1, **characterized in that**, a width of the first supporting plate (111) is less than a width of the second supporting plate (112).

3. The washing machine support (100) according to claim 1, **characterized in that**, the one transition structure (114) is a curved structure provided at the junction of the first supporting plate (111) and the connecting plate (113).

4. The washing machine support (100) according to claim 1, wherein, a first groove (115a) is provided on a second surface of the first supporting plate (111); the first groove (115a) is disposed at a position corresponding to a position of the connecting plate (113); the connecting plate (113) extends outwards from the center of the support (100);
a depth of the first groove (115a) decreases outwards from a center of the support (100).

5. The washing machine support (100) according to claim 1, wherein, a second groove (115b) is provided on a second surface of the second supporting plate (112); the second groove (115b) is disposed at a position corresponding to a position of the connecting plate (113); the connecting plate (113) extends outwards from the center of the support (100);
a depth of the second groove (115b) decreases outwards from a center of the support (100).

6. The washing machine support (100) according to claim 4, **characterized in that**,
the first groove (115a) is a V-shape groove.

7. The washing machine support (100) according to claim 1, **characterized in that**, the first supporting plate (111) and the second supporting plate (112) are connected together at an end of the supporting arm (110) by a connection part (116).

8. The washing machine support (100) according to claim 1, wherein,
a shape of the through groove (117) is adapted to a shape of the end portion of the supporting arm (110), and is configured to make a material distribution at the end portion of the supporting arm (110) tend to be uniform; and
the through groove (117) is provided with a recess (118) facing a center of the support (100); and the recess (118) is in a shape of a triangle.

9. The washing machine support (100) according to claim 1, **characterized in that**, middle regions of the first supporting plate (111) and the second supporting plate (112) are waist-like structures (121a, 121b), and
a waisting degree of the waist-like structure (121a) of the first supporting plate (111) is greater than a waisting degree of the waist-like structure (121b) of the second supporting plate (112).

10. The washing machine support (100) according to claim 1, **characterized in that**, a height of the connecting plate (113) decreases outwards from a center.

11. The washing machine support (100) according to claim 1, **characterized in that**, three or more supporting arms (110) are provided; wherein the first supporting plates (111) of two adjacent supporting arms (110) smoothly transition and are smoothly connected; the second supporting plates (112) of two adjacent supporting arms (110) smoothly transition and are smoothly connected; and a spacing plate (119) is provided between a junction of the first supporting plates (111) of two adjacent supporting arms (110) and a junction of the second supporting plates (112) of two adjacent supporting arms (110).

12. The washing machine support (100) according to claim 11, **characterized in that**, a width of the first supporting plate (111) is less than a width of the second supporting plate (112), and the spacing plate (119) has a wedge-shaped structure corresponding to the width of the first supporting plate (111) and the width the second supporting plate (112).

13. The washing machine support (100) according to claim 5, wherein a first groove (115a) is provided on a second surface of the first supporting plate (111); the first groove (115a) is disposed at a position corresponding to a position of the connecting plate (113); a depth of the first groove (115a) decreases outwards from a center of the support (100).

14. A washing machine, **characterized by** comprising the washing machine support (100) of any one of claims 1-13 and an inner drum (200), wherein the washing machine support (100) is connected to a rear connector (210) of the inner drum (200).

## Patentansprüche

1. Waschmaschinenträger (100) zum Tragen einer Innentrommel (200) einer Waschmaschine, umfassend mindestens zwei Tragarme (110), wobei jeder der Tragarme (110) eine erste Tragplatte (111), eine Verbindungsplatte (113) und eine zweite Tragplatte (112) umfasst, die gegenüber der ersten Tragplatte (111) angeordnet ist; ein erstes Ende der Verbindungsplatte (113) mit einer ersten Oberfläche der ersten Tragplatte (111) verbunden ist; eine erste Oberfläche der zweiten Tragplatte (112) mit einem zweiten Ende der Verbindungsplatte (113) verbunden ist;
eine Übergangsstruktur (114) an einer Verbindungsstelle der ersten Tragplatte (111) und der Verbindungsplatte (113) vorgesehen ist; eine weitere Übergangsstruktur (114) an einer Verbindungsstelle der zweiten Tragplatte (112) und der Verbindungsplatte (113) vorgesehen ist; **dadurch gekennzeichnet, dass** eine durchgehende Nut (117) in einem Endabschnitt des Tragarms (110) angeordnet ist und durch die erste Tragplatte (111) und die zweite Tragplatte (112) verläuft.

2. Waschmaschinenträger (100) nach Anspruch 1, **dadurch gekennzeichnet, dass** eine Breite der ersten Tragplatte (111) geringer ist als eine Breite der zweiten Tragplatte (112).

3. Waschmaschinenträger (100) nach Anspruch 1, **dadurch gekennzeichnet, dass** die eine Übergangsstruktur (114) eine gekrümmte Struktur ist, die an der Verbindungsstelle zwischen der ersten Tragplatte (111) und der Verbindungsplatte (113) vorgesehen ist.

4. Waschmaschinenträger (100) nach Anspruch 1, wobei eine erste Nut (115a) auf einer zweiten Oberfläche der ersten Tragplatte (111) vorgesehen ist; die erste Nut (115a) an einer Position angeordnet ist, die einer Position der Verbindungsplatte (113) entspricht; die Verbindungsplatte (113) sich von der Mitte des Trägers (100) nach außen erstreckt;
eine Tiefe der ersten Nut (115a) von der Mitte des Trägers (100) nach außen hin abnimmt.

5. Waschmaschinenträger (100) nach Anspruch 1, wobei eine zweite Nut (115b) auf einer zweiten Oberfläche der zweiten Tragplatte (112) vorgesehen ist;
die zweite Nut (115b) an einer Position angeordnet ist, die einer Position der Verbindungsplatte (113) entspricht; die Verbindungsplatte (113) sich von der Mitte des Trägers (100) nach außen erstreckt;
eine Tiefe der zweiten Nut (115b) von der Mitte des Trägers (100) nach außen hin abnimmt.

6. Waschmaschinenträger (100) nach Anspruch 4, **dadurch gekennzeichnet, dass** die erste Nut (115a) eine V-förmige Nut ist.

7. Waschmaschinenträger (100) nach Anspruch 1, **dadurch gekennzeichnet, dass** die erste Tragplatte (111) und die zweite Tragplatte (112) an einem Ende des Tragarms (110) durch ein Verbindungsteil (116) miteinander verbunden sind.

8. Waschmaschinenträger (100) nach Anspruch 1, wobei eine Form der Durchgangsnut (117) an eine Form des Endabschnitts des Tragarms (110) angepasst ist und so konfiguriert ist, dass eine Materialverteilung an dem Endabschnitt des Tragarms (110) dazu neigt, gleichmäßig zu sein; und die Durchgangsnut (117) mit einer Aussparung (118) versehen ist, die einer Mitte des Trägers (100) zugewandt ist; und die Aussparung (118) die Form eines Dreiecks aufweist.

9. Waschmaschinenträger (100) nach Anspruch 1, **dadurch gekennzeichnet, dass** mittlere Bereiche der ersten Tragplatte (111) und der zweiten Tragplatte (112) taillenartige Strukturen (121a, 121b) sind, und
ein Taillierungsgrad der taillenartigen Struktur (121a) der ersten Tragplatte (111) größer ist als ein Taillierungsgrad der taillenartigen Struktur (121b) der zweiten Tragplatte (112).

10. Waschmaschinenträger (100) nach Anspruch 1, **dadurch gekennzeichnet, dass** eine Höhe der Verbindungsplatte (113) von einer Mitte nach außen hin abnimmt.

11. Waschmaschinenträger (100) nach Anspruch 1, **dadurch gekennzeichnet, dass** drei oder mehr Tragarme (110) vorgesehen sind; wobei die ersten Tragplatten (111) von zwei benachbarten Tragarmen (110) fließend übergehen und fließend verbunden sind; die zweiten Tragplatten (112) von zwei benachbarten Tragarmen (110) fließend übergehen und fließend verbunden sind; und eine Abstandsplatte (119) zwischen einer Verbindungsstelle der ersten Tragplatten (111) von zwei benachbarten Tragarmen (110) und einer Verbindungsstelle der zweiten Tragplatten (112) von zwei benachbarten Tragarmen (110) vorgesehen ist.

12. Waschmaschinenträger (100) nach Anspruch 11, **dadurch gekennzeichnet, dass** eine Breite der ersten Tragplatte (111) geringer ist als eine Breite der zweiten Tragplatte (112) und die Abstandsplatte (119) eine keilförmige Struktur aufweist, die der Breite der ersten Tragplatte (111) und der Breite der zweiten Tragplatte (112) entspricht.

13. Waschmaschinenträger (100) nach Anspruch 5, wobei eine erste Nut (115a) auf einer zweiten Oberfläche der ersten Tragplatte (111) vorgesehen ist; die erste Nut (115a) an einer Position angeordnet ist, die einer Position der Verbindungsplatte (113) entspricht; eine Tiefe der ersten Nut (115a) von einer Mitte des Trägers (100) nach außen hin abnimmt.

14. Waschmaschine, **dadurch gekennzeichnet, dass** sie den Waschmaschinenträger (100) nach einem der Ansprüche 1 bis 13 und eine Innentrommel (200) umfasst, wobei der Waschmaschinenträger (100) mit einem hinteren Anschluss (210) der Innentrommel (200) verbunden ist.

## Revendications

1. Support de machine à laver (100) pour supporter un tambour intérieur (200) d'une machine à laver, comprenant au moins deux bras de support (110), dans lequel chacun des bras de support (110) comprend une première plaque de support (111), une plaque de connexion (113), et une seconde plaque de support (112) disposée à l'opposé de la première plaque de support (111) ; une première extrémité de la plaque de connexion (113) est reliée à une première surface de la première plaque de support (111) ; une première surface de la seconde plaque de support (112) est reliée à une seconde extrémité de la plaque de connexion (113);
une structure de transition (114) est fournie à une jonction de la première plaque de support (111) et de la plaque de connexion (113) ; une autre structure de transition (114) est fournie à une jonction de la seconde plaque de support (112) et de la plaque de connexion (113) ; **caractérisé en ce que**
une rainure traversante (117) est disposée dans une portion d'extrémité du bras de support (110) et traverse la première plaque de support (111) et la seconde plaque de support (112).

2. Support de machine à laver (100) selon la revendication 1, **caractérisé en ce qu'**une largeur de la première plaque de support (111) est inférieure à une largeur de la seconde plaque de support (112).

3. Support de machine à laver (100) selon la revendication 1, **caractérisé en ce que** la structure de transition (114) est une structure incurvée fournie à la jonction de la première plaque de support (111) et de la plaque de connexion (113).

4. Support de machine à laver (100) selon la revendication 1, dans lequel une première rainure (115a) est fournie sur une seconde surface de la première plaque de support (111) ; la première rainure (115a) est disposée au niveau d'une position correspondant à une position de la plaque de connexion (113) ; la plaque de connexion (113) s'étend vers l'extérieur depuis le centre du support (100) ;
une profondeur de la première rainure (115a) diminue vers l'extérieur depuis un centre du support (100).

5. Support de machine à laver (100) selon la revendication 1, dans lequel une seconde rainure (115b) est fournie sur une seconde surface de la seconde plaque de support (112) ; la seconde rainure (115b) est disposée au niveau d'une position correspondant à une position de la plaque de connexion (113) ; la plaque de connexion (113) s'étend vers l'extérieur depuis le centre du support (100) ; une profondeur de la seconde rainure (115b) diminue vers l'extérieur depuis un centre du support (100).

6. Support de machine à laver (100) selon la revendication 4, **caractérisé en ce que** la première rainure (115a) est une rainure en forme de V.

7. Support de machine à laver (100) selon la revendication 1, **caractérisé en ce que** la première plaque de support (111) et la seconde plaque de support (112) sont reliées ensemble à une extrémité du bras de support (110) par une partie de connexion (116).

8. Support de machine à laver (100) selon la revendication 1, dans lequel une forme de la rainure traversante (117) est adaptée à une forme de la portion d'extrémité du bras de support (110), et est configurée pour faire en sorte qu'une distribution de matériau au niveau de la portion d'extrémité du bras de support (110) tende à être uniforme ; et
la rainure traversante (117) est pourvue d'un évidement (118) faisant face à un centre du support (100) ; et l'évidement (118) a la forme d'un triangle.

9. Support de machine à laver (100) selon la revendication 1, **caractérisé en ce que** des régions centrales de la première plaque de support (111) et de la seconde plaque de support (112) sont des structures cintrées (121a, 121b), et un degré de cintrage de la structure cintrée (121a) de la première plaque de support (111) est supérieur à un degré de cintrage de la structure cintrée (121b) de la seconde plaque de support (112).

10. Support de machine à laver (100) selon la revendication 1, **caractérisé en ce qu'**une hauteur de la plaque de connexion (113) diminue vers l'extérieur depuis un centre.

11. Support de machine à laver (100) selon la revendication 1, **caractérisé en ce que** trois ou plus bras de support (110) sont fournis ; dans lequel les premières plaques de support (111) de deux bras de support (110) adjacents réalisent une transition en douceur et sont reliées en douceur ; les secondes plaques de support (112) de deux bras de support (110) adjacents réalisent une transition en douceur et sont connectées en douceur ; et une plaque d'espacement (119) est fournie entre une jonction des premières plaques de support (111) de deux bras de support (110) adjacents et une jonction des secondes plaques de support (112) de deux bras de support (110) adjacents.

12. Support de machine à laver (100) selon la revendication 11, **caractérisé en ce qu'**une largeur de la première plaque de support (111) est inférieure à une largeur de la seconde plaque de support (112), et la plaque d'espacement (119) a une structure en forme de coin correspondant à la largeur de la première plaque de support (111) et à la largeur de la seconde plaque de support (112).

13. Support de machine à laver (100) selon la revendication 5, dans lequel une première rainure (115a) est fournie sur une seconde surface de la première plaque de support (111) ; la première rainure (115a) est disposée au niveau d'une position correspondant à une position de la plaque de connexion (113) ; une profondeur de la première rainure (115a) diminue vers l'extérieur depuis un centre du support (100).

14. Machine à laver, **caractérisée en ce qu'**elle comprend le support de machine à laver (100) de l'une quelconque des revendications 1-13 et un tambour intérieur (200), dans laquelle le support de machine à laver (100) est relié à un connecteur arrière (210) du tambour intérieur (200).
